# FASCICULE DE BREVET EUROPEEN

(11) **EP 3 375 753 B1**
(45) Date de publication et mention de la délivrance du brevet: **09.12.2020**
(21) Numéro de dépôt: 18161932.1
(22) Date de dépôt: 15.03.2018
(51) Int. Cl.: B81B 7/00

(54) **MICRO-DISPOSITIF A PLUSIEURS ELEMENTS MOBILES DISPOSES AU SEIN DE PLUSIEURS CAVITES IMBRIQUEES**
MIKROVORRICHTUNG MIT MEHREREN BEWEGLICHEN ELEMENTEN, DIE IM INNEREN VON MEHREREN EINGEBETTETEN HOHLRÄUMEN ANGEORDNET SIND
MICRODEVICE WITH A PLURALITY OF MOBILE ELEMENTS ARRANGED WITHIN A PLURALITY OF INTERLOCKING CAVITIES

(30) Priorité: 16.03.2017 FR 1752157
(43) Date de publication de la demande: 19.09.2018
(73) Titulaire: Commissariat à l'énergie atomique et aux énergies alternatives, 75015 Paris (FR); SAFRAN, 75015 Paris (FR)
(72) Inventeur: BERTHELOT, Audrey, 38330 SAINT-ISMIER (FR); COLIN, Mikaël, 38000 GRENOBLE (FR)
(74) Mandataire: Brevalex

(56) Documents cités:
- US-A1- 2005 035 682
- US-A1- 2006 284 514
- US-A1- 2012 230 079

## Description

### DOMAINE TECHNIQUE ET ART ANTÉRIEUR

L'invention concerne le domaine des micro-dispositifs, notamment celui des micro-dispositifs de type microsystèmes électromécaniques (MEMS) et/ou nanosystèmes électromécaniques (NEMS) et/ou microsystèmes opto-électromécaniques (MOEMS) et/ou nanosystèmes opto-électromécaniques (NOEMS), comportant des parties mobiles aptes à se déplacer sous l'effet d'une action extérieure (mécanique, électrique, magnétique) par rapport à une partie fixe du dispositif. Par la suite, le terme « micro-dispositif » est utilisé pour désigner en particulier un dispositif de type MEMS et/ou NEMS et/ou MOEMS et/ou NOEMS.

Les micro-dispositifs sont généralement réalisés par la mise en œuvre de techniques classiques de gravure collective d'une plaque de matériau semi-conducteur (par exemple de silicium). Ils sont petits et peu coûteux à fabriquer. Les domaines d'applications peuvent être très variés, allant des produits grands publics jusqu'à des domaines d'applications très spécifiques.

Pour leur bon fonctionnement, ces micro-dispositifs sont mis en boîtier. Actuellement, la technique de packaging, ou de mise en boîtier, la plus utilisée dans le domaine des micro-dispositifs est le WLP (« Wafer Level Packaging », ou mise en boîtier à l'échelle du substrat), selon laquelle les micro-dispositifs réalisés sur un même substrat sont mis en boîtier collectivement avant une découpe du substrat désolidarisant les micro-dispositifs les uns des autres. Un premier substrat sur lequel les micro-dispositifs sont réalisés est mis en contact puis scellé avec un second substrat formant des capots des cavités dans lesquelles se trouvent les micro-dispositifs. Ce scellement permet d'encapsuler collectivement les micro-dispositifs sous une atmosphère contrôlée et d'assurer une étanchéité des cavités ainsi obtenues. Cette solidarisation des deux substrats l'un à l'autre peut se faire par un scellement moléculaire, un scellement anodique, ou bien encore par un scellement eutectique ou par thermocompression utilisant un cordon de scellement entre les substrats. Un tel cordon de scellement comporte par exemple l'un des eutectiques suivants : Al-Ge, Au-Si, Au-Sn, etc.

Sur un même substrat, plusieurs types de micro-dispositifs, correspondant notamment à des capteurs, peuvent être présents : accéléromètres, gyroscopes, magnétomètres, etc. Cependant, ces capteurs ont souvent besoin, pour leur bon fonctionnement, d'être encapsulés sous des pressions différentes. Par exemple, dans le domaine automobile, les accéléromètres nécessitent une pression de fonctionnement de l'ordre de 100 mbar, tandis que les gyromètres, eux, nécessitent des pressions de fonctionnement beaucoup plus faibles (environ 1 µbar). Des matériaux getter peuvent être utilisés pour obtenir ces différentes pressions de fonctionnement, comme cela est décrit dans le document US 2010/0025845 A1.

Dans d'autres domaines, il est possible que différents éléments d'un même micro-dispositif nécessitent des pressions de fonctionnement différentes. Ainsi, certains capteurs inertiels sont composés de plusieurs étages de suspension, mobiles les uns vis-à-vis des autres, et fonctionnant à des pressions différentes. Par exemple, pour isoler un système résonant (formé par exemple d'une masse mobile et d'un cadre fixe) vis-à-vis de vibrations extérieures, une simple liaison mobile entre la masse mobile et le cadre fixe n'est pas suffisante. Un double étage de suspension doit dans ce cas être utilisé. Pour cela, le cadre fixe est lié à un élément mobile intermédiaire auquel la masse mobile est reliée. Dans un tel système résonnant, la masse mobile nécessite une pression optimale de fonctionnement P1, tandis que l'étage intermédiaire de suspension formé par l'élément mobile intermédiaire nécessite une pression de fonctionnement P2 différente de P1.

Dans le document US 2008/0136000 A1, il est décrit un dispositif MEMS dans lequel différents éléments du micro-dispositif sont encapsulés dans des cavités sous pressions différentes. Toutefois, la solution proposée dans ce document n'est adaptée pour encapsuler un micro-dispositif ayant plusieurs étages de suspension en raison de la mobilité des différents éléments les uns par rapport aux autres.

Dans le document US2005/0035682, le dispositif MEMS inclut deux éléments mobiles, le premier élément mobile étant suspendu à un élément fixe et le deuxième élément mobile étant suspendu au premier élément mobile. Le premier élément mobile est relié su second par des éléments de maintien.

### EXPOSÉ DE L'INVENTION

Un but de la présente invention est de proposer un micro-dispositif, par exemple de type MEMS et/ou NEMS, ayant plusieurs étages de suspension, permettant un bon isolement de la partie sensible du micro-dispositif vis-à-vis des vibrations extérieures, et qui permet l'obtention d'atmosphères différentes au sein des différentes cavités du micro-dispositif.

Pour cela, l'invention propose un micro-dispositif comportant au moins :
- un substrat ;
- un élément fixe solidaire du substrat ;
- un premier élément mobile suspendu à l'élément fixe par des premiers éléments de maintien, et apte à se déplacer par rapport à l'élément fixe ;
- un deuxième élément mobile suspendu au premier élément mobile par des deuxièmes éléments de maintien, et apte à se déplacer par rapport au premier élément mobile et à l'élément fixe ;
- une première cavité dont au moins une partie des parois est formée par l'élément fixe et dans laquelle est encapsulé le premier élément mobile ;
- une deuxième cavité disposée au sein de la première cavité, dont au moins une partie des parois est formée par le premier élément mobile, dans laquelle est encapsulé le deuxième élément mobile et qui est isolée de la première cavité, et dans lequel les volumes intérieurs des première et deuxième cavités ne communiquent pas l'un vis-à-vis de l'autre.

Ainsi, il est proposé un micro-dispositif comportant plusieurs cavités imbriquées les unes dans les autres et dont les parois sont en partie formées par les différents éléments fixes et mobiles formant les différents étage de suspension du micro-dispositif. On obtient ainsi une structure bien adaptée pour réaliser la filtration des vibrations extérieures, et qui permet d'avoir différentes atmosphères au sein des différentes cavités.

Le micro-dispositif peut correspondre notamment à un capteur par exemple inertiel, tel qu'un accéléromètre, un gyroscope, un magnétomètre, un capteur de pression, un microphone, etc.

Le micro-dispositif est compatible avec tout type de mode de détection ou d'excitation du deuxième élément mobile : capacitif, piézoélectrique, piézorésistif, etc.

La deuxième cavité peut être fermée, par exemple hermétiquement, vis-à-vis de la première cavité. Plus généralement, la première et/ou la deuxième cavité peut être fermée hermétiquement ou non en fonction des applications visées. Par exemple, lorsque les cavités nécessitent uniquement une isolation vis-à-vis des vibrations, il n'est pas nécessaire de les fermer hermétiquement. Les première et deuxième cavités sont distinctes l'une de l'autre.

L'élément fixe peut former un cadre fixe solidaire du substrat et le premier élément mobile peut former un cadre mobile suspendu au cadre fixe.

Le cadre fixe et le cadre mobile peuvent avoir chacun une forme sensiblement polygonale ou être en forme d'anneau sensiblement circulaire.

Le premier élément mobile peut être apte à se déplacer en translation et/ou en rotation par rapport à l'élément fixe, et/ou le deuxième élément mobile peut être apte à se déplacer en translation et/ou en rotation par rapport au premier élément mobile et à l'élément fixe.

Les premiers éléments de maintien peuvent comporter des premiers bras de maintien en suspension dont les extrémités sont reliées à l'élément fixe et au premier élément mobile, et/ou les deuxièmes éléments de maintien peuvent comporter des deuxièmes bras de maintien en suspension dont les extrémités sont reliées au premier élément mobile et au deuxième élément mobile.

Dans un mode de réalisation particulier, les première et deuxième cavités peuvent avoir leur centre alignés l'un au-dessus de l'autre selon un axe sensiblement perpendiculaire au substrat, et notamment sensiblement perpendiculaire aux faces principales (faces de plus grandes dimensions) du substrat. Dans ce cas, les première et deuxième cavités sont concentriques l'une par rapport à l'autre. D'autres configurations sont toutefois possibles.

Le micro-dispositif peut comporter en outre au moins une première ouverture formée à travers au moins une des parois de la première cavité telle que la pression au sein de la première cavité soit sensiblement égale à une pression extérieure au micro-dispositif, et/ou au moins une deuxième ouverture formée à travers au moins une des parois de la deuxième cavité telle que la pression au sein de la deuxième cavité soit sensiblement égale à la pression extérieure au micro-dispositif (que la première cavité soit fermée hermétiquement ou non).

Le micro-dispositif peut comporter en outre un premier capot solidarisé à l'élément fixe et fermant la première cavité et/ou un deuxième capot solidarisé, par exemple hermétiquement, au premier élément mobile et fermant, par exemple hermétiquement, la deuxième cavité vis-à-vis de la première cavité, le deuxième capot étant mobile par rapport au premier capot et à l'élément fixe.

Dans ce cas, le micro-dispositif peut comporter en outre un premier cordon de scellement solidarisant, par exemple hermétiquement, le premier capot à l'élément fixe, et/ou un deuxième cordon de scellement solidarisant, par exemple hermétiquement, le deuxième capot au premier élément mobile, le deuxième cordon de scellement étant mobile par rapport au premier cordon de scellement, au premier capot et à l'élément fixe.

Le micro-dispositif peut comporter en outre des éléments de détection et/ou de mesure d'un déplacement du premier élément mobile par rapport à l'élément fixe, et/ou des éléments de détection et/ou de mesure d'un déplacement du deuxième élément mobile par rapport au premier élément mobile, et/ou des éléments aptes à déplacer le premier élément mobile par rapport à l'élément fixe, et/ou des éléments aptes à déplacer le deuxième élément mobile par rapport au premier élément mobile.

Le micro-dispositif peut comporter en outre :
- un troisième élément mobile disposé entre les premier et deuxième éléments mobiles, suspendu au premier élément mobile par des troisièmes éléments de maintien, apte à se déplacer par rapport au premier élément mobile et à l'élément fixe, et qui est encapsulé dans la deuxième cavité ;
- une troisième cavité disposée au sein de la deuxième cavité, dont au moins une partie des parois est formée par le troisième élément mobile, dans laquelle est encapsulé le deuxième élément mobile et qui est fermée, par exemple hermétiquement, ou isolée, vis-à-vis de l'atmosphère des première et deuxième cavités ;
et dans lequel le deuxième élément mobile est suspendu au troisième élément mobile par les deuxièmes éléments de maintien, et apte à se déplacer par rapport au troisième élément mobile, au premier élément mobile et à l'élément fixe.

On forme ainsi un triple étage de suspension améliorant l'isolation du deuxième élément mobile vis-à-vis de vibrations extérieures.

L'invention porte également sur un procédé de réalisation d'un micro-dispositif, comportant au moins :
- réalisation d'un élément fixe solidaire d'un substrat ;
- réalisation d'un premier élément mobile suspendu à l'élément fixe par des premier éléments de maintien, et apte à se déplacer par rapport à l'élément fixe ;
- réalisation d'un deuxième élément mobile suspendu au premier élément mobile par des deuxièmes éléments de maintien, et apte à se déplacer par rapport au premier élément mobile et à l'élément fixe ;
- réalisation d'une première cavité dont au moins une partie des parois est formée par l'élément fixe et dans laquelle est encapsulé le premier élément mobile ;
- réalisation d'une deuxième cavité disposée au sein de la première cavité, dont au moins une partie des parois est formée par le premier élément mobile, dans laquelle est encapsulé le deuxième élément mobile et qui est isolée de la première cavité.

La deuxième cavité peut être fermée, par exemple hermétiquement, vis-à-vis de l'atmosphère de la première cavité, et dans lequel les volumes intérieurs des première et deuxième cavités ne communiquent pas l'un vis-à-vis de l'autre.

Dans ce cas, la réalisation de l'élément fixe, du premier élément mobile et du deuxième élément mobile peut comporter la mise en œuvre d'étapes de :
- gravure d'une première couche de matériau, par exemple de semi-conducteur, disposée sur une première couche sacrificielle, par exemple diélectrique, elle-même disposée sur le substrat, telle que des parties restantes de la première couche de matériau forment l'élément fixe, le premier élément mobile, le deuxième élément mobile, les premiers éléments de maintien et les deuxièmes éléments de maintien, puis
- gravure d'une partie de la première couche sacrificielle à travers la première couche de matériau gravée, rendant mobile le premier élément mobile et le deuxième élément mobile par rapport à l'élément fixe.

En outre, la réalisation de la première cavité et de la deuxième cavité peut comporter la mise en œuvre d'un report d'une deuxième couche de matériau, par exemple de semi-conducteur, sur l'élément fixe et le premier élément mobile tel que :
- une première partie de la deuxième couche de matériau soit solidarisée à l'élément fixe,
- une deuxième partie de la deuxième couche de matériau, mobile par rapport à la première partie de la deuxième couche de matériau et formant un deuxième capot de la deuxième cavité, soit solidarisé au premier élément mobile,
- la première partie de la deuxième couche de matériau est solidarisée à un deuxième substrat tel la deuxième couche de matériau soit disposée entre les élément fixe et mobiles et le deuxième substrat qui forme un premier capot de la première cavité,
- la deuxième partie de la deuxième couche de matériau est mobile par rapport au deuxième substrat.

La première couche de matériau et/ou la deuxième couche de matériau peut être monolithique (c'est-à-dire formée d'une seule couche de matériau), et peut comporter un semi-conducteur, ou peut être multicouches (c'est-à-dire formée d'un empilement de couches).

La couche sacrificielle peut être avantageusement une couche diélectrique.

En variante, la réalisation de la première cavité et de la deuxième cavité peut comporter la mise en œuvre des étapes de :
- gravure d'une deuxième couche de matériau, par exemple de semi-conducteur, disposée sur une deuxième couche sacrificielle, par exemple diélectrique, elle-même disposée sur un deuxième substrat, formant une première partie de la deuxième couche de matériau, une deuxième partie de la deuxième couche de matériau et des quatrièmes éléments de maintien tels que la deuxième partie de la deuxième couche de matériau soit apte à être suspendue à la première partie de la deuxième couche de matériau par les quatrièmes éléments de maintien ;
- report de la deuxième couche de matériau sur l'élément fixe et le premier élément mobile tel que la première partie de la deuxième couche de matériau soit solidarisée à l'élément fixe et que la deuxième partie de la deuxième couche de matériau soit solidarisée au premier élément mobile,
- gravure d'une partie de la deuxième couche sacrificielle à travers des ouvertures traversant le deuxième substrat, rendant mobile la deuxième partie de la deuxième couche de matériau par rapport à la première partie de la deuxième couche de matériau et au deuxième substrat.

Le report de la deuxième couche de matériau sur l'élément fixe et le premier élément mobile peut comporter la mise en œuvre d'un collage direct entre la deuxième couche de matériau et l'élément fixe et entre la deuxième couche de matériau et le premier élément mobile, ou bien un scellement entre la deuxième couche de matériau et l'élément fixe par un premier cordon de scellement et un scellement entre la deuxième couche de matériau et le premier élément mobile par un deuxième cordon de scellement. Les cordons de scellement peuvent correspondre à des cordons de scellement comprenant un ou plusieurs matériaux polymères, ou des cordons de scellement comprenant un ou plusieurs matériaux métalliques, par exemple des eutectiques.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1A et 1B représentent un micro-dispositif, objet de la présente invention, selon un premier mode de réalisation,
- les figures 2A et 2B représentent un micro-dispositif, objet de la présente invention, selon un deuxième mode de réalisation,
- les figures 3 à 7 représentent des micro-dispositifs, objets de la présente invention, selon différentes variantes de réalisation,
- les figures 8A à 8F représentent des étapes d'un procédé de réalisation d'un micro-dispositif, objet de la présente invention, selon un mode de réalisation particulier,
- la figure 9 représente un micro-dispositif obtenu en mettant en œuvre un procédé de réalisation, objet de la présente invention, selon une variante du mode de réalisation décrit en lien avec les figures 8A à 8F.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

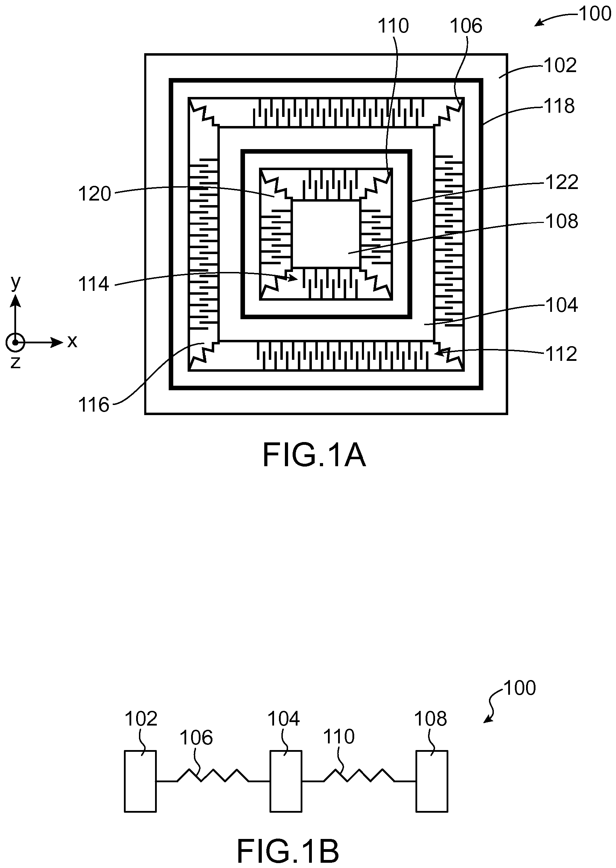

Un micro-dispositif 100 selon un premier mode de réalisation est décrit ci-dessous en lien avec les figures 1A et 1B représentant schématiquement le micro-dispositif 100.

Le micro-dispositif 100 comporte un élément fixe 102 correspondant, dans ce premier mode de réalisation, à un cadre fixe entourant différentes parties mobiles du micro-dispositif 100.

Le micro-dispositif 100 comporte également un premier élément mobile 104 correspondant, dans ce premier mode de réalisation, à un cadre mobile. Le premier élément mobile 104 est disposé à l'intérieur de l'espace entouré par le cadre formé par l'élément fixe 102. De plus, le premier élément mobile 104 est suspendu à l'élément fixe 102 par des premiers moyens de maintien 106 correspondant par exemple à des premiers bras de maintien en suspension pouvant correspondre à des micro-poutres.

Ces premiers moyens de maintien 106 sont tels que le premier élément mobile 104 peut se déplacer selon un ou plusieurs degrés de liberté par rapport à l'élément fixe 102. Ainsi, sur l'exemple de la figure 1A, le cadre mobile formé par le premier élément mobile 104 peut se déplacer en translation par rapport au cadre fixe formé par l'élément fixe 102, parallèlement à l'axe X et parallèlement à l'axe Y. En variante, d'autres types de déplacement du premier élément mobile 104 par rapport à l'élément fixe 102 sont possibles : translation parallèlement à l'axe Z, et/ou une rotation selon au moins l'un des axes X, Y ou Z.

Le micro-dispositif 100 comporte également un deuxième élément mobile 108 correspondant, dans ce premier mode de réalisation, à une masse mobile. Le deuxième élément mobile 108 est disposé à l'intérieur de l'espace entouré par le cadre mobile formé par le premier élément mobile 104. Le deuxième élément mobile 108 est suspendu au premier élément mobile 104 par des deuxièmes moyens de maintien 110 correspondant par exemple à des deuxièmes bras de maintien en suspension pouvant correspondre à des micro-poutres.

Ces deuxièmes moyens de maintien 110 sont tels que le deuxième élément mobile 108 peut se déplacer selon un ou plusieurs degrés de liberté par rapport au premier élément mobile 104, et donc également par rapport à l'élément fixe 102. Ainsi, sur l'exemple de la figure 1A, la masse mobile formée par le deuxième élément mobile 108 peut se déplacer en translation, par rapport au premier élément mobile 104, parallèlement à l'axe X et parallèlement à l'axe Y. En variante, d'autres types de déplacement du deuxième élément mobile 108 par rapport au premier élément mobile 104 sont possibles : translation parallèlement à l'axe Z, et/ou rotation selon au moins l'un des axes X, Y ou Z.

Lorsque les premiers et deuxièmes moyens de maintien 106, 110 sont formés par des micro-poutres, ces micro-poutres peuvent être réalisées sous la forme de ressorts. Ces micro-poutres ont ici des dimensions micrométriques et/ou nanométriques (par exemple comprises entre quelques nanomètres et plusieurs dizaines de micromètres.

Dans ce premier mode de réalisation, le micro-dispositif 100 correspond à un capteur inertiel apte à détecter les déplacements de la masse mobile, formée par le deuxième élément mobile 108, dans le plan (X, Y) par rapport à l'élément fixe 102. Pour détecter ce déplacement, des premiers peignes interdigités 112 sont présents au niveau des faces intérieures du cadre formé par l'élément fixe 102 et au niveau des faces extérieures du cadre formé par le premier élément mobile 104. Ces premiers peignes interdigités 112 assurent la détection du mouvement en translation dans le plan (X,Y) du premier élément mobile 104 par rapport à l'élément fixe 102. Des deuxièmes peignes interdigités 114 sont également présents au niveau des faces intérieures du cadre formé par le premier élément mobile 104 et au niveau des faces extérieures du deuxième élément mobile 108. Ces deuxièmes peignes interdigités 114 assurent la détection du mouvement en translation dans le plan (X,Y) du deuxième élément mobile 108 par rapport au premier élément mobile 104.

Dans le premier mode de réalisation décrit ici, les peignes interdigités 112, 114 assurent une détection capacitive du mouvement des éléments mobiles 104 et 108. En variante, il est possible que le micro-dispositif 100 comporte d'autres moyens de détection des déplacements du premier élément mobile 104 et/ou du deuxième élément mobile 108, en remplacement ou en complément des peignes interdigités 112, 114. Ces moyens de détection sont par exemple capacitifs et/ou piézoélectriques et/ou piézorésistifs, etc.

En outre, il est également possible que le micro-dispositif 100 comporte des moyens d'excitation du premier élément mobile 104 et/ou du deuxième élément mobile 108, aptes à mettre en mouvement le premier élément mobile 104 et/ou le deuxième élément mobile 108. Comme pour les moyens de détection, les moyens d'excitation correspondent par exemple à des éléments de type capacitif, piézoélectrique, piézorésistif, etc.

Dans le premier mode de réalisation décrit en lien avec les figures 1A et 1B, le deuxième élément mobile 108 dont le mouvement est destiné à être détecté est relié à l'élément fixe 102 par l'intermédiaire de deux moyens de suspension 106, 110 successifs et indépendants l'un vis-à-vis de l'autre. Ainsi, si le micro-dispositif 100 est soumis à des vibrations extérieures, ces vibrations mettent en mouvement l'élément fixe 102 mais pas les éléments mobiles 104 et 108. Aucun mouvement n'est donc détecté par les deuxièmes peignes interdigités 114. Le micro-dispositif 100 peut donc émettre un signal de sortie représentatif du mouvement du deuxième élément mobile 108 indépendamment du mouvement de l'élément fixe 102.

Bien que non visibles sur les figures 1A et 1B, les éléments du micro-dispositif 100 sont réalisés sur un substrat auquel l'élément fixe 102 est solidaire.

Le premier élément mobile 104 est encapsulé au sein d'une première cavité 116 qui peut être fermée hermétiquement vis-à-vis de l'environnement extérieur au micro-dispositif 100 et délimitée par le substrat, les faces intérieures de l'élément fixe 102 (qui forment au moins une partie des parois latérales de cette première cavité 116) et un premier capot (non visible sur les figures 1A et 1B) solidarisé sur l'élément fixe 102 par l'intermédiaire d'un premier cordon de scellement 118. De plus, le deuxième élément mobile 108 est encapsulé au sein d'une deuxième cavité 120 qui est ici fermée hermétiquement vis-à-vis de l'atmosphère régnant au sein de la première cavité 116, ou plus généralement isolée vis-à-vis de la première cavité 116, et délimitée par le substrat, les faces intérieures du premier élément mobile 104 (qui forment au moins une partie des parois latérales de cette deuxième cavité 120) et un deuxième capot (non visible sur les figures 1A et 1B) solidarisé sur le premier élément mobile 104 par l'intermédiaire d'un deuxième cordon de scellement 122. Le deuxième cordon de scellement 122 et le deuxième capot sont, comme le premier élément mobile 104, mobiles par rapport à l'élément fixe 102. En outre, le premier cordon de scellement 118 et le premier capot sont fixes vis-à-vis du substrat sur lequel le micro-dispositif 100 est réalisé.

Du fait que les volumes intérieurs de chacune des cavités 116, 120 ne communiquent pas l'un vis-à-vis de l'autre, le premier élément mobile 104 peut être encapsulé dans une atmosphère différente de celle dans laquelle est encapsulé le deuxième élément mobile 108, c'est-à-dire en présence de gaz et/ou d'une pression différents. Par exemple, il est possible que la pression à l'intérieur de la première cavité 116 corresponde à la pression atmosphérique (avec dans ce cas une première cavité 116 qui n'est pas fermée hermétiquement vis-à-vis de l'environnement extérieur) et que l'intérieur de la deuxième cavité 120 soit à une pression P1 différente de la pression atmosphérique.

De plus, la fermeture des différentes cavités du micro-dispositif 100 peut être réalisée en mettant en œuvre une seule étape de fermeture des premier et deuxième capots à l'échelle du substrat.

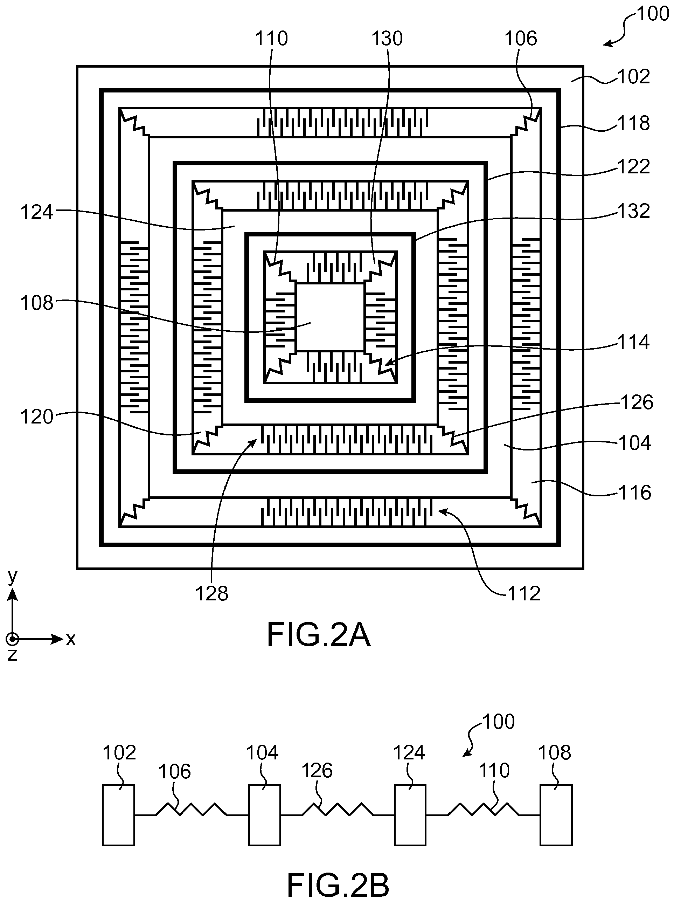

Un autre micro-dispositif 100 selon un deuxième mode de réalisation est représenté schématiquement sur les figures 2A et 2B.

Comme dans le premier mode de réalisation précédemment décrit, le micro-dispositif 100 représenté sur les figures 2A et 2B comportent l'élément fixe 102 auquel est suspendu le premier élément mobile 104 par les premiers moyens de maintien 106. Ce micro-dispositif 100 comporte également le deuxième élément mobile 108 formant la masse mobile du micro-dispositif 100 dont les déplacements sont destinés à être détectés.

Toutefois, contrairement au premier mode de réalisation dans lequel le deuxième élément mobile 108 est suspendu au premier élément mobile 104 par l'intermédiaire des deuxièmes moyens de maintien 110, le micro-dispositif 100 comporte un troisième élément mobile 124 interposé entre les premier et deuxième éléments mobiles 104, 108. Dans ce deuxième mode de réalisation, le deuxième élément mobile 108 est disposé à l'intérieur de l'espace entouré par le cadre formé par le troisième élément mobile 124, et est suspendu au troisième élément mobile 124 par les deuxièmes moyens de maintien 110. Le deuxième élément mobile 108 peut donc se déplacer selon un ou plusieurs degrés de liberté par rapport au troisième élément mobile 124.

Le troisième élément mobile 124 est disposé à l'intérieur de l'espace entouré par le cadre formé par le premier élément mobile 104. De plus, le troisième élément mobile 124 est suspendu au premier élément mobile 104 par des troisièmes moyens de maintien 126 correspondant par exemple à des micro-poutres. Ces troisièmes moyens de maintien 126 sont tels que le troisième élément mobile 124 peut se déplacer selon un ou plusieurs degrés de liberté par rapport au premier élément mobile 104, et donc également par rapport à l'élément fixe 102. Sur l'exemple de la figure 2A, le troisième élément mobile 124 peut se déplacer en translation parallèlement à l'axe X et parallèlement à l'axe Y. En variante, d'autres types de déplacement du troisième élément mobile 124 par rapport au premier élément mobile 104 sont possibles : translation parallèlement à l'axe X, rotation selon au moins l'un des axes X, Y ou Z, etc.

Afin d'assurer la continuité de la détection du mouvement du deuxième élément mobile 108 depuis le centre du micro-dispositif 100 jusqu'à l'élément fixe 102, le micro-dispositif 100 comporte, en plus des premiers peignes interdigités 112 présents au niveau des faces intérieures du cadre formé par l'élément fixe 102 et au niveau des faces extérieures du cadre formé par le premier élément mobile 104, et des deuxièmes peignes interdigités 114 présents au niveau des faces intérieures du cadre formé par le troisième élément mobile 124 et au niveau des faces extérieures du deuxième élément mobile 108, des troisièmes peignes interdigités 128 présents au niveau des faces intérieures du cadre formé par le premier élément mobile 104 et au niveau des faces extérieures du cadre formé par le troisième élément mobile 124. Ces troisièmes peignes interdigités 114 assurent la détection du mouvement en translation dans le plan (X,Y) du troisième élément mobile 124 par rapport au premier élément mobile 104.

En variante, il est possible que le micro-dispositif 100 comporte d'autres moyens de détection des déplacements du premier élément mobile 104 et/ou du deuxième élément mobile 108 et/ou du troisième élément mobile 124, en remplacement ou en complément des peignes interdigités 112, 114 et 128. Ces moyens de détection sont par exemple capacitifs et/ou piézoélectriques et/ou piézorésistifs, etc.

Dans ce deuxième mode de réalisation décrit en lien avec les figures 2A et 2B, le deuxième élément mobile 108 dont le mouvement est destiné à être détecté est relié à l'élément fixe 102 par trois moyens de suspension 106, 126, 110 successifs et indépendants les uns vis-à-vis des autres. Par rapport au premier mode de réalisation, cette configuration améliore encore plus l'isolation du deuxième élément mobile 108 par rapport aux vibrations, ou plus généralement aux perturbations mécaniques, extérieures que subit le micro-dispositif 100.

Comme dans le premier mode de réalisation, le premier élément mobile 104 est encapsulé au sein de la première cavité 116 qui peut être fermée hermétiquement vis-à-vis de l'environnement extérieur au micro-dispositif 100 et délimitée par le substrat, les faces intérieures de l'élément fixe 102 (qui forment au moins une partie des parois latérales de cette première cavité 116) et le premier capot (non visible sur les figures 2A et 2B) solidarisé sur l'élément fixe 102 par l'intermédiaire du premier cordon de scellement 118. Le troisième élément mobile 124 est encapsulé au sein de la deuxième cavité 120 qui est ici fermée hermétiquement vis-à-vis de l'atmosphère régnant au sein de la première cavité 116, ou bien isolée vis-à-vis de la première cavité 116, et délimitée par le substrat, les faces intérieures du premier élément mobile 104 (qui forment au moins une partie des parois latérales de cette deuxième cavité 120) et le deuxième capot (non visible sur les figures 2A et 2B) solidarisé sur le premier élément mobile 104 par l'intermédiaire du deuxième cordon de scellement 122. Le deuxième cordon de scellement 122 et le deuxième capot sont, comme le premier élément mobile 104, mobiles par rapport à l'élément fixe 102. Enfin, le deuxième élément mobile 108 est encapsulé au sein d'une troisième cavité 130 qui est par exemple fermée hermétiquement, ou plus généralement isolée, vis-à-vis des atmosphères régnant au sein des première et deuxième cavité 116 et 120, et délimitée par le substrat, les faces intérieures du troisième élément mobile 124 (qui forment au moins une partie des parois latérales de cette troisième cavité 130) et un troisième capot (non visible sur les figures 2A et 2B) solidarisé sur le troisième élément mobile 124 par l'intermédiaire d'un troisième cordon de scellement 132. Le troisième cordon de scellement 132 et le troisième capot sont, comme le troisième élément mobile 124, mobiles par rapport au premier élément mobile 104 ainsi que par rapport à l'élément fixe 102.

Du fait que chacune des cavités 116, 120 et 130 soit isolées les unes vis-à-vis des autres, le premier élément mobile 104 peut être encapsulé dans une atmosphère différente de celle dans laquelle est encapsulé le deuxième élément mobile 108 et de celle dans laquelle est encapsulé le troisième élément mobile 124, c'est-à-dire en présence de gaz et/ou de pression différents.

Selon d'autres modes de réalisation, il est possible que le micro-dispositif 100 comporte plus de deux éléments mobiles intermédiaires interposés, via des moyens de suspension distincts, entre l'élément fixe et l'élément mobile formant la masse mobile du micro-dispositif 100.

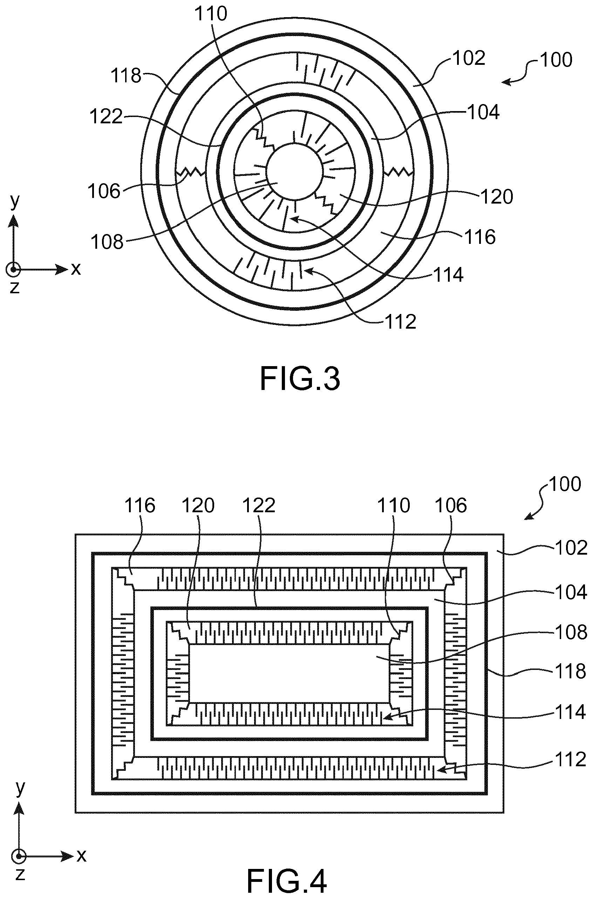

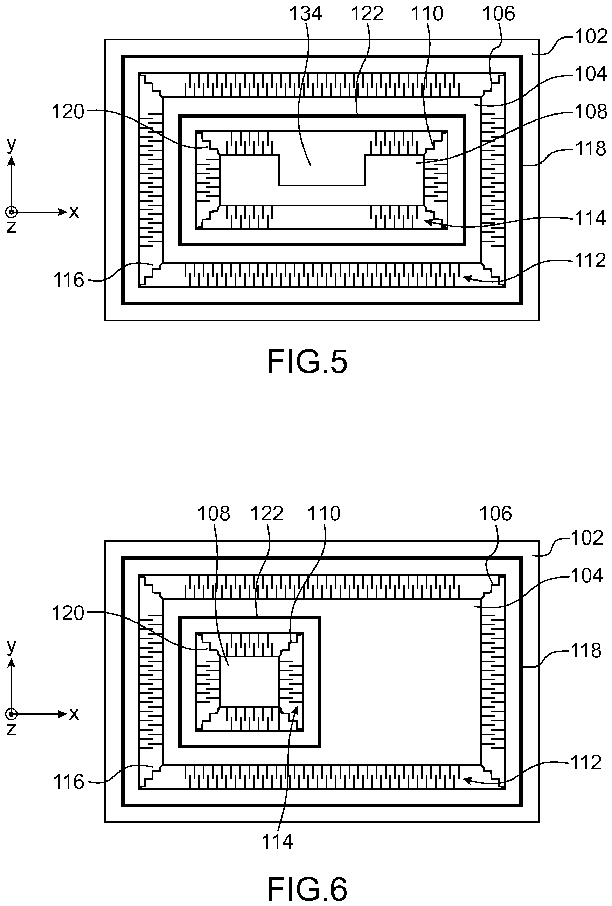

Dans les deux modes de réalisation décrits ci-dessus, les éléments 102, 104 et 124 ont des sections, dans le plan du substrat sur lequel le micro-dispositif 100 est réalisé, formant des cadres sensiblement carrés. En variante, d'autres formes sont envisageables. Par exemple, le micro-dispositif 100 représenté sur la figure 3 comporte des éléments 102 et 104 de forme, dans le plan (X,Y) sensiblement parallèle au substrat, annulaire. Le deuxième élément mobile 108 a une forme, dans le plan (X,Y), de disque. Les cavités 116 et 120 ont donc ici des formes cylindriques. Selon un autre exemple, le micro-dispositif 100 représenté sur la figure 4 comporte des éléments 102 et 104 formant, dans le plan (X,Y), des cadres rectangulaires. Le deuxième élément mobile 108 a également, dans le plan (X,Y), une forme rectangulaire. La figure 5 représente un autre micro-dispositif 100 dans lequel, contrairement aux précédents exemples dans lesquels le deuxième élément mobile 108 a une forme correspondant sensiblement à celle de la cavité dans laquelle il est encapsulé, le deuxième élément 108 a ici une forme différente de celle de la cavité 120 dans laquelle il est encapsulé. Sur cet exemple de réalisation particulier représenté sur la figure 5, le deuxième élément mobile 108 a une forme, dans le plan (X,Y), présentant un creux 134. Dans cet exemple de réalisation particulier, la structure est symétrique par rapport à un axe parallèle à l'axe Y (contrairement aux structures des précédents modes de réalisation qui sont symétriques par rapport à leur centre).

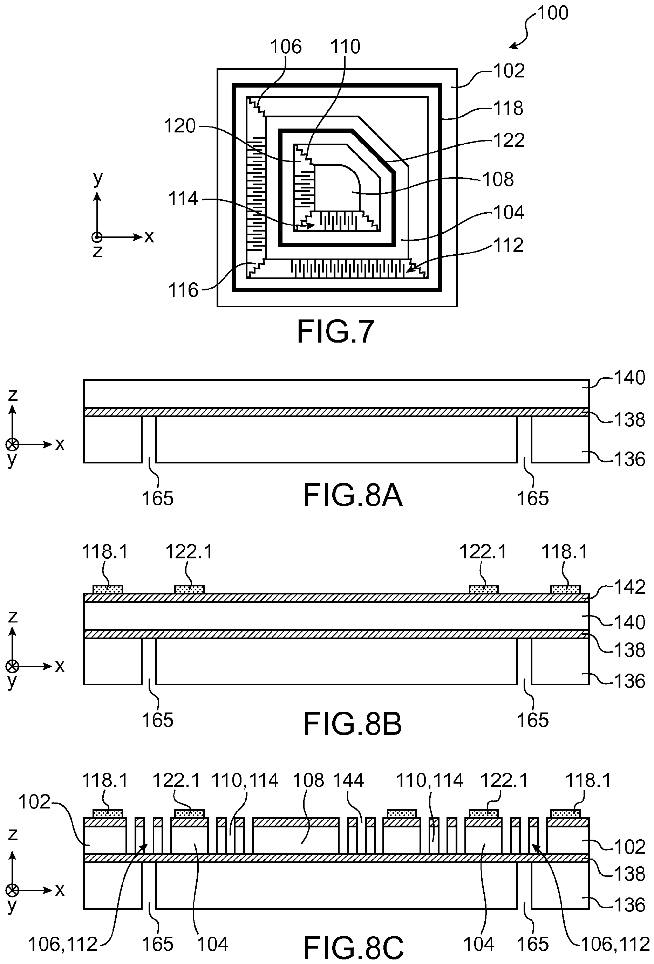

Dans les exemples de réalisation précédemment décrits en lien avec les figures 1A à 5, les différentes cavités imbriquées les unes dans les autres au sein du micro-dispositif 100 sont concentriques, c'est-à-dire comportent leur centre disposés les uns au-dessus des autres. En variante, il est possible que les centres de ces cavités soient décalés les uns par rapport aux autres. Par exemple, dans le micro-dispositif 100 représenté sur la figure 6, la deuxième cavité 120 n'est pas centrée par rapport à la première cavité 116 du fait qu'un des côtés du premier élément mobile 104 est beaucoup plus important que les autres côtés. Selon un autre exemple de réalisation représenté sur la figure 7, les cavités 116 et 120 ne sont pas concentriques du fait que la cavité 116 n'a pas la même forme, dans le plan (X,Y), que la cavité 120.

Dans les différents modes et exemples de réalisation précédemment décrits, les différentes cavités d'un même micro-dispositif 100 peuvent être fermées simultanément au cours d'une seule étape de fermeture mise en œuvre collectivement à l'échelle du substrat.

De plus, bien que les différentes cavités d'un même micro-dispositif 100 puissent être fermées simultanément par la mise en œuvre d'une même étape de fermeture collective à l'échelle du substrat, les matériaux utilisés pour former les différents cordons de scellement des différentes cavités d'un même micro-dispositif 100 peuvent être différents d'un cordon de scellement à l'autre.

Pour réaliser les cordons de scellement, il est possible de réaliser une première partie du cordon sur la face de l'élément sur lequel un capot est destiné à être solidarisé, et une deuxième partie du cordon sur la face du capot destiné à être solidarisé à l'un des éléments du micro-dispositif. Par exemple, il est possible de déposer un premier matériau de collage sur le capot, et de déposer un deuxième matériau de collage sur l'élément fixe ou mobile du micro-dispositif 100, ces premier et deuxième matériaux de collage pouvant être similaires ou non. Les matériaux du cordon de scellement sont avantageusement des matériaux métalliques tels que des alliages eutectiques. Par exemple, un cordon de scellement peut être réalisé à partir de portions d'Au-Si solidarisées l'une contre l'autre pour former le cordon de scellement. Il est également possible que l'une des portions du cordon comporte de l'Au-Si et que l'autre des portions du cordon comporte de l'Au-Sn.

Dans les modes de réalisation et exemples précédemment décrits, les capots sont solidarisés aux différents éléments fixes et mobiles du micro-dispositif 100 par l'intermédiaire de cordons de scellement 118, 122 et 132. Ces cordons de scellements peuvent comporter des matériaux métalliques lorsque les capots sont solidarisés aux éléments fixes et mobiles du micro-dispositif 100. Il est également possible que ces cordons de scellement comportent un ou plusieurs matériaux non métalliques, par exemple un ou plusieurs matériaux polymères. En variante, il est possible que les capots soient solidarisés aux différents éléments fixes et mobiles du micro-dispositif 100 via la mise en œuvre d'un collage direct. Dans ce cas, aucun cordon de scellement n'est présent entre les capots et les éléments fixes et mobiles du micro-dispositif 100.

Un procédé de réalisation d'un micro-dispositif 100 selon un mode de réalisation particulier est maintenant décrit en lien avec les figures 8A à 8F. Le micro-dispositif 100 obtenu par la mise en œuvre de ce procédé correspond au micro-dispositif 100 précédemment décrit en lien avec les figures 1A et 1B.

Le micro-dispositif 100 est par exemple réalisé à partir d'un premier substrat de type semi-conducteur sur isolant, par exemple SOI (silicium sur isolant). Ce substrat, visible sur la figure 8A, comporte une couche support 136, une couche diélectrique enterrée 138, ou BOX (« Buried Oxide »), comprenant par exemple de l'oxyde de semi-conducteur tel que du SiO₂, et une couche superficielle de semi-conducteur 140 comprenant par exemple du silicium. L'épaisseur totale des couches 138 et 140 est par exemple comprise entre environ 100 nm et 100 µm. Des tranchées 165 sont réalisées à travers la couche support 136.

De manière générale, la couche 140 correspond à une couche de matériau adapté à la réalisation des différents éléments fixes et mobiles du micro-dispositif 100. La couche 138 correspond à une couche de matériau sacrificiel.

En variante, le micro-dispositif 100 peut être réalisé à partir d'un substrat massif 136, ou bulk, comprenant par exemple un semi-conducteur tel que du silicium, sur lequel sont déposées successivement une couche sacrificielle 138, par exemple diélectrique telle qu'une couche d'oxyde de semi-conducteur, et une couche de matériau 140 dans laquelle les structures mobiles du micro-dispositif 100 seront réalisés, correspondant par exemple à une couche de semi-conducteur tel que du silicium dopé ou non, du germanium dopé ou non, etc. La couche sacrificielle 138 et la couche de matériau 140 peuvent être formées en mettant en œuvre différentes techniques telles que des dépôts de type LPCVD (dépôt chimique par phase vapeur basse pression), PECVD (dépôt chimique par phase vapeur assisté par plasma), ALD (dépôt de couche atomique), PVD (dépôt physique par phase vapeur), ou encore par épitaxie, etc.

Une couche diélectrique 142 est ensuite réalisée sur la couche superficielle 140. Une couche d'un premier matériau du cordon de scellement est ensuite déposée sur la couche diélectrique 142. Ce premier matériau est par exemple un matériau métallique, tel que de l'Au, de l'Al ou du SnAg, ou bien un matériau semi-conducteur tel que du Ge. Cette couche du premier matériau du cordon de scellement est gravée afin de former des premières parties des différents cordons de scellement que le micro-dispositif 100 est destiné à comporter. Sur l'exemple de la figure 8B, la couche est gravée et les portions restantes de cette couche conservées sur la couche diélectrique 142 correspondent à une première partie 118.1 du premier cordon de scellement 118 et à une première partie 122.1 du deuxième cordon de scellement 122.

Comme représenté sur la figure 8C, une gravure est ensuite mise en œuvre à travers les couches 142 et 140 afin de former, au sein de la couche de semi-conducteur 140, les différents éléments fixes et mobiles du micro-dispositif 100 (l'élément 102 et les éléments mobiles 104 et 108 sur l'exemple de la figure 8C) ainsi que les moyens de maintien par lesquels les éléments mobiles sont destinés à être suspendus (micro-poutres 106 et 110 sur l'exemple de la figure 8C), et aussi les éléments de détection et/ou d'actionnement du micro-dispositif 100 (premiers et deuxièmes peignes interdigités 112 et 114 sur l'exemple de la figure 8C). Les tranchées gravées à travers les couches 142 et 140 qui délimitent les différents éléments du micro-dispositif 100 forment également les espaces qui serviront ensuite à libérer les différents éléments du micro-dispositif 100. Si nécessaire, la gravure mise en œuvre à cette étape du procédé peut également servir à réaliser des trous de libération supplémentaires 144 à travers les couches 142 et 140 si les tranchées définissant les différents éléments du micro-dispositif 100 ne sont pas suffisantes pour la libération ultérieure de ces éléments. Sur l'exemple de la figure 8C, des trous de libération 144 sont formés à travers le deuxième élément mobile 108 afin que le matériau de la couche 138 se trouvant sous le deuxième élément mobile 108 puisse être correctement gravé.

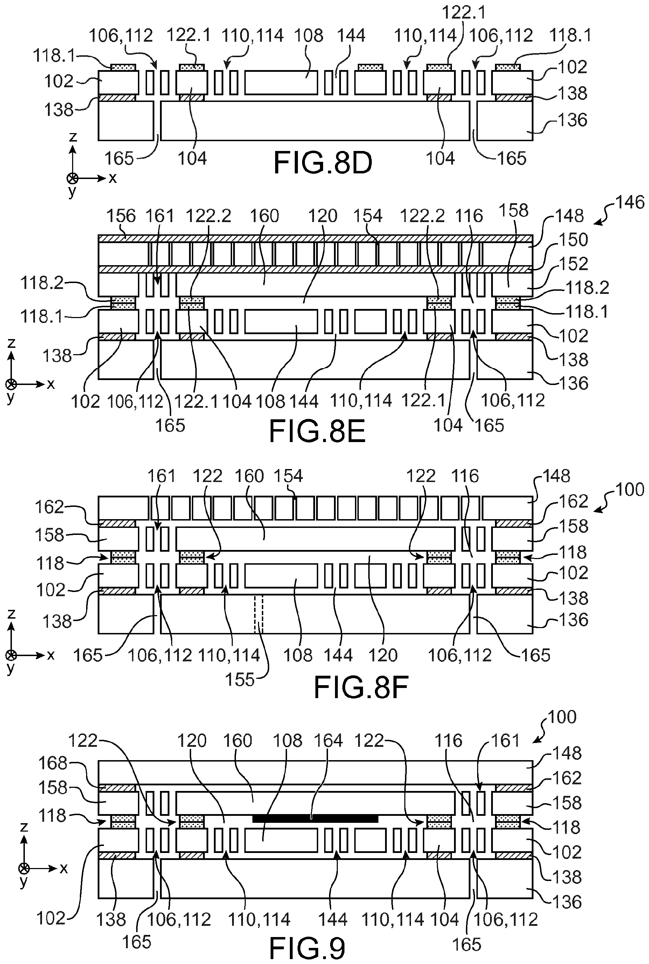

Une gravure d'une partie de la couche 138 est ensuite mise en œuvre à travers les tranchées et les éventuels trous de libération 144 réalisés lors de la précédente étape de gravure, afin de libérer les éléments mobiles 108 et 104 du micro-dispositif 100 (voir figure 8D). Des portions de la couche 138 sont conservées sous l'élément mobile 104. La mobilité de l'élément mobile 104 par rapport à la partie fixe 102 est assurée par les tranchées 165.

Un second substrat 146 est ensuite reporté sur la structure précédemment réalisée afin de former les capots des cavités dans lesquelles sont encapsulés les éléments mobiles 104 et 108 du micro-dispositif 100. Dans l'exemple représenté sur la figure 8E, ce second substrat 146 correspond à un substrat de type semi-conducteur sur isolant tel qu'un substrat SOI comportant une couche support 148, une couche diélectrique enterrée 150 et une couche superficielle de semi-conducteur 152 comprenant par exemple du silicium. Le second substrat 146 est ici solidarisé aux différents éléments fixes et mobiles du micro-dispositif 100 via la mise en œuvre d'un scellement métallique. Sur l'exemple de la figure 8E, des deuxièmes parties 118.2 et 122.2 des cordons de scellement 118, 122 sont formés au préalable sur la couche superficielle 152, puis ces deuxièmes parties 118.2 et 122.2 des cordons de scellement 118, 122 sont mises en contact contre les premières parties 118.1 et 122.1 des cordons de scellement 118, 122, et un recuit achève la formation des cordons de scellement 118 et 122. Les cordons de scellement 118, 122 sont par exemple formés par des premières parties 118.1 et 122.1 comprenant de l'Au et des deuxièmes parties 118.2 et 122.2 comprenant du Si ou de l'Au ou du Sn, ou bien par des premières parties 118.1 et 122.1 comprenant de l'Al et des deuxièmes parties 118.2 et 122.2 comprenant du Ge.

En variante, le second substrat 146 pourrait être solidarisé à l'ensemble précédemment réalisé via la mise en œuvre d'un scellement direct, ou collage direct, par exemple silicium contre silicium, ou diélectrique contre diélectrique, ou diélectrique contre silicium, etc. Selon une autre variante, des cordons d'un ou plusieurs matériaux non-métalliques, par exemple polymères, pourraient être formés entre le second substrat 146 et la structure précédemment réalisée comportant les différents éléments du micro-dispositif 100.

Dans l'exemple de réalisation représenté sur la figure 8E, des trous de libération 154 traversent la couche support 148 et forment des accès à la couche diélectrique enterrée 150. Ces trous de libération 154 sont bouchés temporairement via une couche diélectrique 156 recouvrant la face de la couche support 148 opposée à celle contre laquelle se trouve la couche diélectrique enterrée 150.

Avant le report du second substrat 146, la couche superficielle 152 est structurée afin de former différentes parties destinées à faire partie des différents capots des cavités dans lesquelles les différentes parties mobiles du micro-dispositif 100 sont encapsulées. Ainsi, sur l'exemple de la figure 8E, une première partie 158 de la couche superficielle 152, qui est fixe par rapport à l'élément fixe 102, forme, avec la couche support 148, le premier capot de la première cavité 116. Une deuxième partie 160 de la couche superficielle 152 est mobile par rapport à la première partie 158 grâce à des moyens 161 de maintien en suspension, par exemple des bras de type micro-poutres, de cette deuxième partie 160 par rapport à la première partie 158. Cette deuxième partie 160 de la couche superficielle 152 forme le deuxième capot de la deuxième cavité 120.

Selon un exemple de réalisation particulier, il est possible qu'au moins une ouverture 155 (représentée en pointillé sur la figure 8E) soit réalisée à travers la couche support 136 afin de faire communiquer l'intérieur de la deuxième cavité 120 avec l'atmosphère extérieure dans laquelle se trouve le micro-dispositif 100. Dans ce cas, la pression au sein de la deuxième cavité 120 correspond à la pression à l'extérieur du micro-dispositif 100.

Le micro-dispositif 100 est achevé en gravant la couche diélectrique 156 ainsi que les parties de la couche diélectrique enterrée 150 accessibles via les trous de libération 154, libérant ainsi la deuxième partie 160 de la couche superficielle 152 vis-à-vis de la couche support 148 et rendant ainsi mobile le deuxième capot vis-à-vis du premier capot (figure 8F). En raison des trous de libération 154 non bouchés, la pression au sein de la première cavité 116 correspond à la pression à l'extérieur du micro-dispositif 100.

Ainsi, le micro-dispositif 100 obtenu et représenté sur la figure 8F comporte :
- un premier élément fixe 102 solidarisé au substrat 136 par l'intermédiaire des portions restantes de la couche diélectrique enterrée 138 ;
- un premier élément mobile 104 suspendu à l'élément fixe 102 par les moyens de maintien 106 ici de type bras formés par des micro-poutres ;
- une première cavité 116 dans laquelle est encapsulé le premier élément mobile 104, dont les parois latérales sont formées par des portions restantes de la couche 138, l'élément fixe 102, le premier cordon de scellement 118, la première partie 158 de la couche superficielle 152 et des portions restantes 162 de la couche diélectrique enterrée 150, ainsi que par le premier capot formé par la couche support 148 (et ici traversé par les trous de libération 154) ;
- un deuxième élément mobile 108 suspendu au premier élément mobile 104 par les moyens de maintien 110, 114 ici de type bras formés par des micro-poutres ;
- une deuxième cavité 120 dans laquelle est encapsulé le deuxième élément mobile 108, dont les parois latérales sont formées par des portions restantes de la couche 138, le premier élément mobile 104 et le deuxième cordon de scellement 122, ainsi que par le deuxième capot formé par la deuxième partie 160 de la couche superficielle 152.

Un procédé de réalisation du micro-dispositif 100 selon une variante du mode de réalisation ci-dessus est maintenant décrit.

Les étapes précédemment décrites en lien avec les figures 8A à 8D sont tout d'abord mises en œuvre.

Ensuite, avant de reporter le second substrat 146 sur la structure obtenue, la couche diélectrique enterrée 150 est retirée sélectivement par rapport à la couche support 148 et la couche superficielle de semi-conducteur 152 afin d'assurer la mobilité de la deuxième partie 160 de la couche superficielle 152, qui est destinée à former le deuxième capot de la deuxième cavité 120, par rapport à la première partie 158 de cette couche 152 destinée à former une partie des parois latérales de la première cavité 116.

De manière optionnelle, une portion ou couche de matériau getter 164 peut être disposée contre la deuxième partie 160 de la couche superficielle 152 afin qu'après le report du second substrat 146, la portion de matériau getter 164 soit encapsulée dans la deuxième cavité 120. Dans ce cas, la température à laquelle est réalisé le scellement du second substrat 146, ainsi que la nature du matériau getter utilisé pour la portion 164, peuvent être avantageusement choisies telles que le matériau getter de la portion 164 soit activé thermiquement au cours de ce scellement, c'est-à-dire telles que la température d'activation thermique du matériau getter soit inférieure ou égale à celle de la température à laquelle est mis en œuvre le scellement.

Le second substrat 146 est alors reporté et scellé à la structure précédemment réalisée, achevant la réalisation du micro-dispositif 100. Le micro-dispositif 100 obtenu est représenté sur la figure 9.

Dans cette variante de réalisation, la différence de pressions régnant dans les première et deuxième cavités 116, 120 est due non pas au fait que la pression dans la première cavité 116 est égale à la pression atmosphérique obtenue grâce à des trous traversant la couche 148, mais grâce à l'absorption et/ou l'adsorption gazeuse réalisée par la portion de matériau getter 164 dans la deuxième cavité 120.

## Revendications

1. Micro-dispositif (100) comportant au moins :
- un substrat (136),
- un élément fixe (102) solidaire du substrat (136),
- un premier élément mobile (104) suspendu à l'élément fixe (102) par des premiers éléments de maintien (106), et apte à se déplacer par rapport à l'élément fixe (102),
- un deuxième élément mobile (108) suspendu au premier élément mobile (104) par des deuxièmes éléments de maintien (110), et apte à se déplacer par rapport au premier élément mobile (104) et à l'élément fixe (102),
- une première cavité (116) dont au moins une partie des parois est formée par l'élément fixe (102) et dans laquelle est encapsulé le premier élément mobile (104),
- une deuxième cavité (120) disposée au sein de la première cavité (116), dont au moins une partie des parois est formée par le premier élément mobile (104), dans laquelle est encapsulé le deuxième élément mobile (108) et qui est isolée de la première cavité (116),
**caractérisé par le fait que** les volumes intérieurs des première et deuxième cavités (116, 120) ne communiquent pas l'un vis-à-vis de l'autre.

2. Micro-dispositif (100) selon la revendication 1, dans lequel l'élément fixe (102) forme un cadre fixe solidaire du substrat (136) et dans lequel le premier élément mobile (104) forme un cadre mobile suspendu au cadre fixe.

3. Micro-dispositif (100) selon l'une des revendications précédentes, dans lequel le premier élément mobile (104) est apte à se déplacer en translation et/ou en rotation par rapport à l'élément fixe (102), et/ou dans lequel le deuxième élément mobile (108) est apte à se déplacer en translation et/ou en rotation par rapport au premier élément mobile (104) et à l'élément fixe (102).

4. Micro-dispositif (100) selon l'une des revendications précédentes, dans lequel les premiers éléments de maintien (106) comportent des premiers bras de maintien en suspension dont les extrémités sont reliées à l'élément fixe (102) et au premier élément mobile (104), et/ou dans lequel les deuxièmes éléments de maintien (110) comportent des deuxièmes bras de maintien en suspension dont les extrémités sont reliées au premier élément mobile (104) et au deuxième élément mobile (108).

5. Micro-dispositif (100) selon l'une des revendications précédentes, dans lequel les première et deuxième cavités (116, 120) ont leur centre alignés l'un au-dessus de l'autre selon un axe sensiblement perpendiculaire au substrat (136).

6. Micro-dispositif (100) selon l'une des revendications précédentes, comportant en outre au moins une première ouverture (154) formée à travers au moins une des parois de la première cavité (116) telle que la pression au sein de la première cavité (116) soit sensiblement égale à une pression extérieure au micro-dispositif (100), et/ou au moins une deuxième ouverture (155) formée à travers au moins une des parois de la deuxième cavité (120) telle que la pression au sein de la deuxième cavité (120) soit sensiblement égale à la pression extérieure au micro-dispositif (100).

7. Micro-dispositif (100) selon l'une des revendications précédentes, comportant en outre un premier capot (148, 158) solidarisé à l'élément fixe (102) et fermant la première cavité (116) et/ou un deuxième capot (160) solidarisé au premier élément mobile (104) et fermant la deuxième cavité (120) vis-à-vis de la première cavité (116), le deuxième capot (160) étant mobile par rapport au premier capot (148, 158) et à l'élément fixe (102).

8. Micro-dispositif (100) selon la revendication 7, comportant en outre un premier cordon de scellement (118) solidarisant le premier capot (148, 158) à l'élément fixe (102), et/ou un deuxième cordon de scellement (122) solidarisant le deuxième capot (160) au premier élément mobile (104), le deuxième cordon de scellement (122) étant mobile par rapport au premier cordon de scellement (118), au premier capot (148, 158) et à l'élément fixe (102).

9. Micro-dispositif (100) selon l'une des revendications précédentes, comportant en outre des éléments (112) de détection et/ou de mesure d'un déplacement du premier élément mobile (104) par rapport à l'élément fixe (102), et/ou des éléments (114) de détection et/ou de mesure d'un déplacement du deuxième élément mobile (108) par rapport au premier élément mobile (104), et/ou des éléments aptes à déplacer le premier élément mobile (104) par rapport à l'élément fixe (102), et/ou des éléments aptes à déplacer le deuxième élément mobile (108) par rapport au premier élément mobile (104).

10. Micro-dispositif (100) selon l'une des revendications précédentes, comportant en outre :
- un troisième élément mobile (124) disposé entre les premier et deuxième éléments mobiles (104, 108), suspendu au premier élément mobile (104) par des troisièmes éléments de maintien (126), apte à se déplacer par rapport au premier élément mobile (104) et à l'élément fixe (102), et qui est encapsulé dans la deuxième cavité (120),
- une troisième cavité (130) disposée au sein de la deuxième cavité (120), dont au moins une partie des parois est formée par le troisième élément mobile (124), dans laquelle est encapsulé le deuxième élément mobile (108) et qui est fermée vis-à-vis de l'atmosphère des première et deuxième cavités (116, 120),
et dans lequel le deuxième élément mobile (108) est suspendu au troisième élément mobile (124) par les deuxièmes éléments de maintien (110), et apte à se déplacer par rapport au troisième élément mobile (124), au premier élément mobile (104) et à l'élément fixe (102).

11. Procédé de réalisation d'un micro-dispositif (100), comportant au moins :
- réalisation d'un élément fixe (102) solidaire d'un substrat (136) ;
- réalisation d'un premier élément mobile (104) suspendu à l'élément fixe (102) par des premiers éléments de maintien (106), et apte à se déplacer par rapport à l'élément fixe (102),
- réalisation d'un deuxième élément mobile (108) suspendu au premier élément mobile (104) par des deuxièmes éléments de maintien (110), et apte à se déplacer par rapport au premier élément mobile (104) et à l'élément fixe (102),
- réalisation d'une première cavité (116) dont au moins une partie des parois est formée par l'élément fixe (102) et dans laquelle est encapsulé le premier élément mobile (104),
- réalisation d'une deuxième cavité (120) disposée au sein de la première cavité (116), dont au moins une partie des parois est formée par le premier élément mobile (104), dans laquelle est encapsulé le deuxième élément mobile (108) et qui est isolée de la première cavité (116)
**caractérisé en ce que** les volumes intérieurs des première et deuxième cavités (116, 120) ne communiquent pas l'un vis-à-vis de l'autre.

12. Procédé selon la revendication 11, dans lequel la réalisation de l'élément fixe (102), du premier élément mobile (104) et du deuxième élément mobile (108) comporte la mise en œuvre d'étapes de :
- gravure d'une première couche de matériau (140) disposée sur une première couche sacrificielle (138) elle-même disposée sur le substrat (136), telle que des parties restantes de la première couche de matériau (140) forment l'élément fixe (102), le premier élément mobile (104), le deuxième élément mobile (108), les premiers éléments de maintien (106) et les deuxièmes éléments de maintien (110), puis
- gravure d'une partie de la première couche sacrificielle (138) à travers la première couche de matériau (140) gravée, rendant mobile le premier élément mobile (104) et le deuxième élément mobile (108) par rapport à l'élément fixe (102).

13. Procédé selon l'une des revendications 11 et 12, dans lequel la réalisation de la première cavité (116) et de la deuxième cavité (120) comporte la mise en œuvre d'un report d'une deuxième couche de matériau (152) sur l'élément fixe (102) et le premier élément mobile (104) tel que :
- une première partie (158) de la deuxième couche de matériau (152) soit solidarisée à l'élément fixe (102),
- une deuxième partie (160) de la deuxième couche de matériau (152), mobile par rapport à la première partie (158) de la deuxième couche de matériau (152) et formant un deuxième capot de la deuxième cavité (120), soit solidarisé au premier élément mobile (104),
- la première partie (158) de la deuxième couche de matériau (152) est solidarisée à un deuxième substrat (148) tel la deuxième couche de matériau (152) soit disposée entre les élément fixe et mobiles (102, 104, 108) et le deuxième substrat (148) qui forme un premier capot de la première cavité (116),
- la deuxième partie (160) de la deuxième couche de matériau (152) est mobile par rapport au deuxième substrat (148).

14. Procédé selon l'une des revendications 11 et 12, dans lequel la réalisation de la première cavité (116) et de la deuxième cavité (120) comporte la mise en œuvre des étapes de :
- gravure d'une deuxième couche de matériau (152) disposée sur une deuxième couche sacrificielle (150) elle-même disposée sur un deuxième substrat (148), formant une première partie (158) de la deuxième couche de matériau (152), une deuxième partie (160) de la deuxième couche de matériau (152) et des quatrièmes éléments de maintien (161) tels que la deuxième partie (160) de la deuxième couche de matériau (152) soit apte à être suspendue à la première partie (158) de la deuxième couche de matériau (152) par les quatrièmes éléments de maintien (161),
- report de la deuxième couche de matériau (152) sur l'élément fixe (102) et le premier élément mobile (104) tel que la première partie (158) de la deuxième couche de matériau (152) soit solidarisée à l'élément fixe (102) et que la deuxième partie (160) de la deuxième couche de matériau (152) soit solidarisée au premier élément mobile (104),
- gravure d'une partie de la deuxième couche sacrificielle (150) à travers des ouvertures (154) traversant le deuxième substrat (148), rendant mobile la deuxième partie (160) de la deuxième couche de matériau (152) par rapport à la première partie (158) de la deuxième couche de matériau (152) et au deuxième substrat (148).

15. Procédé selon l'une des revendications 13 et 14, dans lequel le report de la deuxième couche de matériau (152) sur l'élément fixe (102) et le premier élément mobile (104) comporte la mise en œuvre d'un collage direct entre la deuxième couche de matériau (152) et l'élément fixe (102) et entre la deuxième couche de matériau (152) et le premier élément mobile (104), ou un scellement entre la deuxième couche de matériau (152) et l'élément fixe (102) par un premier cordon de scellement (118) et un scellement entre la deuxième couche de matériau (152) et le premier élément mobile (104) par un deuxième cordon de scellement (122).

## Patentansprüche

1. Mikrovorrichtung (100), zumindest enthaltend:
- ein Substrat (136),
- ein feststehendes Element (102), das fest mit dem Substrat (136) verbunden ist,
- ein erstes bewegliches Element (104), das mit ersten Halteelementen (106) an dem feststehenden Element (102) aufgehängt und dazu geeignet ist, sich relativ zu dem feststehenden Element (102) zu verlagern,
- ein zweites bewegliches Element (108), das mit zweiten Halteelementen (110) an dem ersten beweglichen Element (104) aufgehängt und dazu geeignet ist, sich relativ zu dem ersten beweglichen Element (104) und zu dem feststehenden Element (102) zu verlagern,
- einen ersten Hohlraum (116), dessen Wände zumindest teilweise aus dem feststehenden Element (102) gebildet sind und in dem das erste bewegliche Element (104) eingekapselt ist,
- einen zweiten Hohlraum (120), der innerhalb des ersten Hohlraums (116) angeordnet ist, dessen Wände zumindest teilweise aus dem ersten beweglichen Element (104) gebildet sind und in dem das zweite bewegliche Element (108) eingekapselt ist und der von dem ersten Hohlraum (116) isoliert ist,
**dadurch gekennzeichnet, dass**
die Innenräume des ersten und des zweiten Hohlraums (116, 120) nicht miteinander kommunizieren.

2. Mikrovorrichtung (100) nach Anspruch 1, wobei das feststehende Element (102) einen feststehenden Rahmen bildet, der fest mit dem Substrat (136) verbunden ist, und wobei das erste bewegliche Element (104) einen beweglichen Rahmen bildet, der an dem feststehenden Rahmen aufgehängt ist.

3. Mikrovorrichtung (100) nach einem der vorangehenden Ansprüche, wobei das erste bewegliche Element (104) dazu geeignet ist, sich translatorisch und/oder drehend relativ zu dem feststehenden Element (102) zu verlagern, und/oder wobei das zweite bewegliche Element (108) dazu geeignet ist, sich translatorisch und/oder drehend relativ zu dem ersten beweglichen Element (104) und zu dem feststehenden Element (102) zu verlagern.

4. Mikrovorrichtung (100) nach einem der vorangehenden Ansprüche, wobei die ersten Halteelemente (106) erste Aufhängungshaltearme enthalten, deren Enden mit dem feststehenden Element (102) und mit dem ersten beweglichen Element (104) verbunden sind, und/oder wobei die zweiten Halteelemente (110) zweite Aufhängungshaltearme enthalten, deren Enden mit dem ersten beweglichen Element (104) und mit dem zweiten beweglichen Element (108) verbunden sind.

5. Mikrovorrichtung (100) nach einem der vorangehenden Ansprüche, wobei der erste und der zweite Hohlraum (116, 120) mit ihren Mittelpunkten entlang einer im Wesentlichen senkrecht zum Substrat (136) verlaufenden Achse übereinander ausgerichtet sind.

6. Mikrovorrichtung (100) nach einem der vorangehenden Ansprüche, ferner enthaltend zumindest eine erste Öffnung (154), die durch zumindest eine der Wände des ersten Hohlraums (116) hindurch so ausgebildet ist, dass der Druck innerhalb des ersten Hohlraums (116) im Wesentlichen gleich einem Druck außerhalb der Mikrovorrichtung (100) ist, und/oder zumindest eine zweite Öffnung (155), die durch zumindest eine der Wände des zweiten Hohlraums (120) hindurch so ausgebildet ist, dass der Druck innerhalb des zweiten Hohlraums (120) im Wesentlichen gleich dem Druck außerhalb der Mikrovorrichtung (100) ist.

7. Mikrovorrichtung (100) nach einem der vorangehenden Ansprüche, ferner enthaltend eine erste Kappe (148, 158), die mit dem feststehenden Element (102) fest verbunden ist und den ersten Hohlraum (116) verschließt, und/oder eine zweite Kappe (160), die mit dem ersten beweglichen Element (104) fest verbunden ist und den zweiten Hohlraum (120) gegenüber dem ersten Hohlraum (116) verschließt, wobei die zweite Kappe (160) relativ zu der ersten Kappe (148, 158) und zu dem feststehenden Element (102) beweglich ist.

8. Mikrovorrichtung (100) nach Anspruch 7, ferner enthaltend einen ersten Dichtungsstrang (118), der die erste Kappe (148, 158) fest mit dem feststehenden Element (102) verbindet, und/oder einen zweiten Dichtungsstrang (122), der die zweite Kappe (160) fest mit dem ersten beweglichen Element (104) verbindet, wobei der zweite Dichtungsstrang (122) relativ zu dem ersten Dichtungsstrang (118), zu der ersten Kappe (148, 158) und zu dem feststehenden Element (102) beweglich ist.

9. Mikrovorrichtung (100) nach einem der vorangehenden Ansprüche, ferner enthaltend Elemente (112) zum Erfassen und/oder Messen einer Verlagerung des ersten beweglichen Elements (104) relativ zu dem feststehenden Element (102) und/oder Elemente (114) zum Erfassen und/oder Messen einer Verlagerung des zweiten beweglichen Elements (108) relativ zu dem ersten beweglichen Element (104), und/oder Elemente, die dazu geeignet sind, das erste bewegliche Element (104) relativ zu dem feststehenden Element (102) zu verlagern, und/oder Elemente, die dazu geeignet sind, das zweite bewegliche Element (108) relativ zu dem ersten beweglichen Element (104) zu verlagern.

10. Mikrovorrichtung (100) nach einem der vorangehenden Ansprüche, ferner enthaltend:
- ein drittes bewegliches Element (124), das zwischen dem ersten und dem zweiten beweglichen Element (104, 108) angeordnet ist, mit dritten Halteelementen (126) an dem ersten beweglichen Element (104) aufgehängt ist, dazu geeignet ist, sich relativ zu dem ersten beweglichen Element (104) und zu dem feststehenden Element (102) zu verlagern und in dem zweiten Hohlraum (120) eingekapselt ist,
- einen dritten Hohlraum (130), der innerhalb des zweiten Hohlraums (120) angeordnet ist, dessen Wände zumindest teilweise aus dem dritten beweglichen Element (124) gebildet sind und in dem das zweite bewegliche Element (108) eingekapselt ist und der gegenüber der Atmosphäre des ersten und des zweiten Hohlraums (116, 120) abgeschlossen ist,
wobei das zweite bewegliche Element (108) mit zweiten Halteelementen (110) am dritten beweglichen Element (124) aufgehängt und dazu geeignet ist, sich relativ zu dem dritten beweglichen Element (124), zu dem ersten beweglichen Element (104) und zu dem feststehenden Element (102) zu verlagern.

11. Verfahren zur Herstellung einer Mikrovorrichtung (100), zumindest umfassend:
- Herstellen eines feststehenden Elements (102), das fest mit einem Substrat (136) verbunden ist;
- Herstellen eines ersten beweglichen Elements (104), das mit ersten Halteelementen (106) an dem feststehenden Element (102) aufgehängt und dazu geeignet ist, sich relativ zu dem feststehenden Element (102) zu verlagern,
- Herstellen eines zweiten beweglichen Elements (108), das mit zweiten Halteelementen (110) an dem ersten beweglichen Element (104) aufgehängt und dazu geeignet ist, sich relativ zu dem ersten beweglichen Element (104) und zu dem feststehenden Element (102) zu verlagern,
- Herstellen eines ersten Hohlraums (116), dessen Wände zumindest teilweise aus dem feststehenden Element (102) gebildet sind und in dem das erste bewegliche Element (104) eingekapselt ist,
- Herstellen eines zweiten Hohlraums (120), der innerhalb des ersten Hohlraums (116) angeordnet ist, dessen Wände zumindest teilweise aus dem ersten beweglichen Element (104) gebildet sind, in dem das zweite bewegliche Element (108) eingekapselt ist und der vom ersten Hohlraum (116) isoliert ist, **dadurch gekennzeichnet, dass** die Innenräume des ersten und des zweiten Hohlraums (116, 120) nicht miteinander kommunizieren.

12. Verfahren nach Anspruch 11, wobei das Herstellen des feststehenden Elements (102), des ersten beweglichen Elements (104) und des zweiten beweglichen Elements (108) die Ausführung der folgenden Schritte umfasst:
- Ätzen einer ersten Materialschicht (140), die auf einer ersten Opferschicht (138) angeordnet ist, die ihrerseits auf dem Substrat (136) angeordnet ist, so dass die verbleibenden Abschnitte der ersten Materialschicht (140) das feststehende Element (102), das erste bewegliche Element (104), das zweite bewegliche Element (108), die ersten Halteelemente (106) und die zweiten Halteelemente (110) bilden, dann
- Ätzen eines Teils der ersten Opferschicht (138) durch die geätzte erste Materialschicht (140) hindurch, wodurch das erste bewegliche Element (104) und das zweite bewegliche Element (108) relativ zu dem feststehenden Element (102) beweglich gemacht werden.

13. Verfahren nach einem der Ansprüche 11 und 12, wobei das Herstellen des ersten Hohlraums (116) und des zweiten Hohlraums (120) die Durchführung einer Übertragung einer zweiten Materialschicht (152) auf das feststehende Element (102) und auf das erste bewegliche Element (104) umfasst, so dass:
- ein erster Teil (158) der zweiten Materialschicht (152) fest mit dem feststehenden Element (102) verbunden wird,
- ein zweiter Teil (160) der zweiten Materialschicht (152), der relativ zu dem ersten Teil (158) der zweiten Materialschicht (152) beweglich ist und eine zweite Kappe des zweiten Hohlraums (120) bildet, fest mit dem ersten beweglichen Element (104) verbunden wird,
- der erste Teil (158) der zweiten Materialschicht (152) fest mit einem zweiten Substrat (148) verbunden wird, so dass die zweite Materialschicht (152) zwischen dem feststehenden und den beweglichen Elementen (102, 104, 108) und dem zweiten Substrat (148), das eine erste Kappe des ersten Hohlraums (116) bildet, angeordnet ist,
- der zweite Teil (160) der zweiten Materialschicht (152) relativ zu dem zweiten Substrat (148) beweglich ist.

14. Verfahren nach einem der Ansprüche 11 und 12, wobei das Herstellen des ersten Hohlraums (116) und des zweiten Hohlraums (120) die Ausführung der folgenden Schritte umfasst:
- Ätzen einer zweiten Materialschicht (152), die auf einer zweiten Opferschicht (150) angeordnet ist, die ihrerseits auf einem zweiten Substrat (148) angeordnet ist, wodurch ein erster Teil (158) der zweiten Materialschicht (152), ein zweiter Teil (160) der zweiten Materialschicht (152) und vierte Halteelemente (161) so gebildet werden, dass der zweite Teil (160) der zweiten Materialschicht (152) dazu geeignet ist, mit den vierten Halteelementen (161) an dem ersten Teil (158) der zweiten Materialschicht (152) aufgehängt zu werden,
- Übertragen der zweiten Materialschicht (152) auf das feststehende Element (102) und auf das erste bewegliche Element (104), so dass der erste Teil (158) der zweiten Materialschicht (152) fest mit dem feststehenden Element (102) verbunden wird und der zweite Teil (160) der zweiten Materialschicht (152) fest mit dem ersten beweglichen Element (104) verbunden wird,
- Ätzen eines Teils der zweiten Opferschicht (150) durch Öffnungen (154) hindurch, die durch das zweite Substrat (148) verlaufen, wodurch der zweite Teil (160) der zweiten Materialschicht (152) relativ zu dem ersten Teil (158) der zweiten Materialschicht (152) und zu dem zweiten Substrat (148) beweglich gemacht wird.

15. Verfahren nach einem der Ansprüche 13 und 14, wobei das Übertragen der zweiten Materialschicht (152) auf das feststehende Element (102) und auf das erste bewegliche Element (104) das Ausführen einer direkten Verklebung zwischen der zweiten Materialschicht (152) und dem feststehenden Element (102) und zwischen der zweiten Materialschicht (152) und dem ersten beweglichen Element (104) umfasst oder eine Abdichtung zwischen der zweiten Materialschicht (152) und dem feststehenden Element (102) durch einen ersten Dichtungsstrang (118) und eine Abdichtung zwischen der zweiten Materialschicht (152) und dem ersten beweglichen Element (104) durch einen zweiten Dichtungsstrang (122) umfasst.

## Claims

1. Micro-device (100) comprising at least:
- a substrate (136),
- a stationary element (102) rigidly connected to the substrate (136),
- a first mobile element (104) suspended from the stationary element (102) by first retention elements (106) and configured to move with respect to the stationary element (102),
- a second mobile element (108) suspended from the first mobile element (104) by second retention elements (110) and configured to move with respect to the first mobile element (104) and the stationary element (102),
- a first cavity (116), at least some of the walls of which is formed by the stationary element (102) and in which the first mobile element (104) is encapsulated,
- a second cavity (120) positioned in the first cavity (116), at least some of the walls of which is formed by the first mobile element (104), in which the second mobile element (108) is encapsulated and which is insulated from the first cavity (116),
**characterized in that** the inner volumes of the first and second cavities (116, 120) are not connected to each other.

2. Micro-device (100) according to claim 1, wherein the stationary element (102) forms a stationary frame rigidly connected to the substrate (136) and wherein the first mobile element (104) forms a mobile frame suspended from the stationary frame.

3. Micro-device (100) according to one of previous claims, wherein the first mobile element (104) is configured to move in translation and/or in rotation with respect to the stationary element (102), and/or the second mobile element (108) is configured to move in translation and/or in rotation with respect to the first mobile element (104) and the stationary element (102).

4. Micro-device (100) according to one of previous claims, wherein the first retention elements (106) comprise first arms for retaining in suspension, the ends of which are connected to the stationary element (102) and to the first mobile element (104), and/or the second retention elements (110) comprise second arms for retaining in suspension, the ends of which are connected to the first mobile element (104) and to the second mobile element (108).

5. Micro-device (100) according to one of previous claims, wherein the centres of the first and second cavities (116, 120) are aligned one above the other along an axis substantially perpendicular to the substrate (136).

6. Micro-device (100) according to one of previous claims, further comprising at least one first opening (154) formed through at least one of the walls of the first cavity (116) such that the pressure in the first cavity (116) is substantially equal to a pressure outside of the micro-device (100), and/or at least one second opening (155) formed through at least one of the walls of the second cavity (120), such that the pressure in the second cavity (120) is substantially equal to the pressure outside of the micro-device (100).

7. Micro-device (100) according to one of previous claims, further comprising a first cover (148, 158) rigidly connected to the stationary element (102) and sealing the first cavity (116) and/or a second cover (160) rigidly connected to the first mobile element (104) and sealing the second cavity (120) with respect to the first cavity (116), the second cover (160) being mobile with respect to the first cover (148, 158) and the stationary element (102).

8. Micro-device (100) according to claim 7, further comprising a first sealing bead (118) rigidly connecting the first cover (148, 158) to the stationary element (102), and/or a second sealing bead (122) rigidly connecting the second cover (160) to the first mobile element (104), the second sealing bead (122) being mobile with respect to the first sealing bead (118), the first cover (148, 158) and the stationary element (102).

9. Micro-device (100) according to one of previous claims, further comprising elements (112) for detection and/or measurement of a movement of the first mobile element (104) with respect to the stationary element (102), and/or elements (114) for detection and/or measurement of a movement of the second mobile element (108) with respect to the first mobile element (104), and/or elements configured to move the first mobile element (104) with respect to the stationary element (102), and/or elements configured to move the second mobile element (108) with respect to the first mobile element (104).

10. Micro-device (100) according to one of previous claims, further comprising:
- a third mobile element (124) positioned between the first and second mobile elements (104, 108), suspended from the first mobile element (104) by third retention elements (126), configured to move with respect to the first mobile element (104) and the stationary element (102), and which is encapsulated in the second cavity (120),
- a third cavity (130) positioned in the second cavity (120), at least some of the walls of which is formed by the third mobile element (124), in which the second mobile element (108) is encapsulated and which is sealed with respect to the atmosphere of the first and second cavities (116, 120),
and wherein the second mobile element (108) is suspended from the third mobile element (124) by the second retention elements (110) and is configured to move with respect to the third mobile element (124), the first mobile element (104) and the stationary element (102).

11. Method for manufacturing a micro-device (100), comprising at least:
- making a stationary element (102) rigidly connected to a substrate (136) ;
- making a first mobile element (104) suspended from the stationary element (102) by first retention elements (106) and configured to move with respect to the stationary element (102),
- making a second mobile element (108) suspended from the first mobile element (104) by second retention elements (110) and configured to move with respect to the first mobile element (104) and the stationary element (102),
- making a first cavity (116), at least some of the walls of which is formed by the stationary element (102) and in which the first mobile element (104) is encapsulated,
- making a second cavity (120) positioned in the first cavity (116), at least some of the walls of which is formed by the first mobile element (104), in which the second mobile element (108) is encapsulated and which is insulated from the first cavity (116),
**characterized in that** the inner volumes of the first and second cavities (116, 120) are not connected to each other.

12. Method according to claim 11, wherein the making of the stationary element (102), of the first mobile element (104) and of the second mobile element (108) comprises the implementation of the following steps:
- etching of a first layer of material (140) positioned on a first sacrificial layer (138) itself positioned on the substrate (136), such that remaining portions of the first layer of material (140) form the stationary element (102), the first mobile element (104), the second mobile element (108), the first retention elements (106) and the second retention elements (110), then
- etching of a portion of the first sacrificial layer (138) through the first etched layer of material (140), making the first mobile element (104) and the second mobile element (108) mobile with respect to the stationary element (102).

13. The method according to one of claims 11 and 12, wherein the making of the first cavity (116) and of the second cavity (120) comprises the implementation of a transfer of a second layer of material (152) onto the stationary element (102) and the first mobile element (104), such that:
- a first portion (158) of the second layer of material (152) is rigidly connected to the stationary element (102),
- a second portion (160) of the second layer of material (152), mobile with respect to the first portion (158) of the second layer of material (152) and forming a second cover of the second cavity (120), is rigidly connected to the first mobile element (104),
- the first portion (158) of the second layer of material (152) is rigidly connected to a second substrate (148) such the second layer of material (152) is positioned between the stationary and mobile elements (102, 104, 108) and the second substrate (148) that forms a first cover of the first cavity (116),
- the second portion (160) of the second layer of material (152) is mobile with respect to the second substrate (148).

14. The method according to one of claims 11 and 12, wherein the making of the first cavity (116) and of the second cavity (120) comprises the implementation of the following steps:
- etching of a second layer of material (152) positioned on a second sacrificial layer (150) itself positioned on a second substrate (148), forming a first portion (158) of the second layer of material (152), a second portion (160) of the second layer of material (152) and fourth retention elements (161) such that the second portion (160) of the second layer of material (152) is configured to be suspended from the first portion (158) of the second layer of material (152) by the fourth retention elements (161),
- transfer of the second layer of material (152) onto the stationary element (102) and the first mobile element (104), such that the first portion (158) of the second layer of material (152) is rigidly connected to the stationary element (102) and the second portion (160) of the second layer of material (152) is rigidly connected to the first mobile element (104),
- etching of a portion of the second sacrificial layer (150) through the openings (154) passing through the second substrate (148), making the second portion (160) of the second layer of material (152) mobile with respect to the first portion (158) of the second layer of material (152) and the second substrate (148).

15. The method according to one of claims 13 and 14, wherein the transfer of the second layer of material (152) onto the stationary element (102) and the first mobile element (104) comprises the implementation of direct bonding between the second layer of material (152) and the stationary element (102) and between the second layer of material (152) and the first mobile element (104), or sealing between the second layer of material (152) and the stationary element (102) by a first sealing bead (118) and sealing between the second layer of material (152) and the first mobile element (104) by a second sealing bead (122).
